Europäisches Patentamt

European Patent Office

Office européen des brevets

(19)

(11) Veröffentlichungsnummer: **0 121 095**
**B1**

(12) **EUROPÄISCHE PATENTSCHRIFT**

(45) Veröffentlichungstag der Patentschrift:
18.01.89

(51) Int. Cl.⁴: **H 01 L 31/06**

(21) Anmeldenummer: **84102071.2**

(22) Anmeldetag: **28.02.84**

(54) Solarzellenmodul.

(30) Priorität: **01.03.83 DE 3307202**

(43) Veröffentlichungstag der Anmeldung:
**10.10.84 Patentblatt 84/41**

(45) Bekanntmachung des Hinweises auf die Patenterteilung:
**18.01.89 Patentblatt 89/3**

(84) Benannte Vertragsstaaten:
**AT BE CH DE FR GB IT LI LU NL SE**

(56) Entgegenhaltungen:
**DE-A- 3 005 560**
**FR-A- 2 170 026**
**US-A- 4 367 365**
**US-A-42 578 211**

(73) Patentinhaber: **Siemens Aktiengesellschaft Berlin und München, Wittelsbacherplatz 2, D-8000 München 2 (DE)**

(72) Erfinder: **Hollaus, Reinhard, Dipl.-Ing., Hohenbrunner Weg 106, D-8028 Taufkirchen (DE)**
Erfinder: **Zehetbauer, Rudolf, Gelbhofstrasse 10, D-8000 München 70 (DE)**
Erfinder: **Bednorz, Klaus, Dipl.-Phys., Leopoldstrasse 138, D-8000 München 40 (DE)**

ACTORUM AG

## Beschreibung

Die Erfindung betrifft ein Solarzellenmodul nach dem Oberbegriff des Anspruchs 1. Ein Solarzellenmodul nach dem Oberbegriff des Anspruchs 1 ist aus US-A-4 257 821 und DE-A-3 005 560 bekannt.

Wenn Solarzellen in Serie geschaltet werden, was bei einem Solarzellenmodul gewöhnlich der Fall ist, dann kann sich bei Stromüberlastung die Spannung an einzelnen Solarzellen und gegebenenfalls auch an einer ganzen «Kette» von Solarzellen umkehren. Eine derartige Stromüberlastung kann sich bei starken Schwankungen des Strahlungseinfalls auf einzelne Solarmodulflächen ergeben. Diese Spannungsumkehr wird durch die sogenannten Bypass- oder Nebenschlussdioden vermieden, wodurch die Heizleistung für schwächer bestrahlte Solarzellen begrenzt wird.

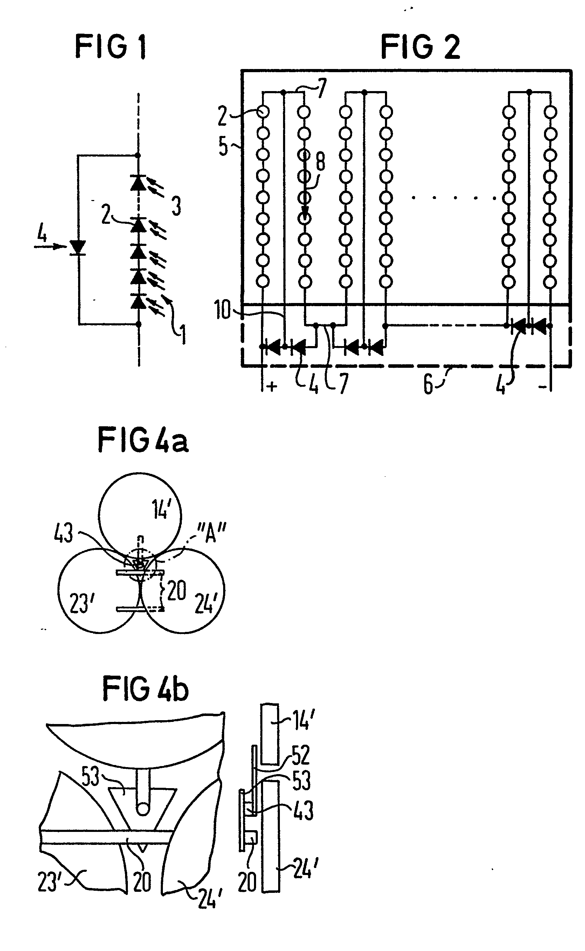

Fig. 1 zeigt ein Prinzipschaltbild einer derartigen Anordnung. Ein Solarzellenmodul weist eine Kette 1 aus mehreren, in Serie geschalteten Solarzellen 2 auf. Die auf die Solarzellen 2 einfallende Strahlung ist schematisch durch Pfeile 3 angedeutet. Eine Bypassdiode 4 liegt in Sperrrichtung parallel zu der Kette 1. Bei einer infolge einer Stromüberlastung eintretenden Spannungsumkehr an den Solarzellen 2 liegt die Bypassdiode 4 in Durchlassrichtung zum «umgekehrten» Stromfluss, wodurch die Kette 1 nahezu kurzgeschlossen wird, so dass die mögliche Heizleistung für eine einzelne Solarzelle durch die in dem kurzgeschlossenen Kreis verbleibenden aktiven Solarzellen begrenzt wird.

Bisher werden die Bypassdioden 4 ausserhalb des eigentlichen Solarzellenverbundes in einem sogenannten Anschlusskasten des Solarzellenmoduls untergebracht. Fig. 2 zeigt schematisch ein solches Solarzellenmodul 5 mit einem Anschlusskasten 6, in dem die einzelnen Bypassdioden 4 vorgesehen sind. Die Solarzellen 2 sind in diesem Solarzellenmodul 5 alle in Serie geschaltet, wie dies durch einen Leiterzug 7 und Pfeile 8 angedeutet ist. Nach jeweils einer Kette aus Solarzellen 2 ist ein gesonderter Leiter 10 aus dem Solarzellenverbund herausgeführt und endet bei den im Anschlusskasten 6 untergebrachten Bypassdioden 4. Jeweils eine Bypassdiode 4 überbrückt so eine Kette aus den Solarzellen 2. Wie aus der Fig. 2 ersichtlich ist, werden bei einem derartigen Solarzellenmodul die zusätzlichen Leiter 10 benötigt, die überdies noch isoliert werden müssen. Auch ist die Montage der einzelnen Bypassdioden 4 im Anschlusskasten 6 aufwendig.

Es ist nun Aufgabe der Erfindung, ein Solarzellenmodul zu schaffen, bei dem die Bypassdioden ohne grossen Aufwand und zusätzliche Leiter angebracht sind.

Diese Aufgabe wird erfindungsgemäss durch die im kennzeichnenden Teil des Anspruchs 1 angegebenen Merkmale gelöst.

Beim erfindungsgemässen Solarzellenmodul werden also keine gesonderten Leiter benötigt, die von den einzelnen Ketten der Solarzellen zu den Bypassdioden führen. Auch kann der Anschlusskasten, in dem bisher die Bypassdioden untergebracht sind, kleiner gemacht werden oder sogar ganz entfallen. Eine aufwendige Montage der Bypassdioden in einem solchen Anschlusskasten ist nicht erforderlich. Weiterhin kann die Isolation vereinfacht werden, da keine besonderen Leiter zu den Bypassdioden führen.

Die Bypassdiode kann direkt zwischen zwei Solarzellen verschiedene Ketten geschaltet werden. Auch ist es möglich, die Bypassdiode mit einer Elektrode direkt auf der Rückseite einer Solarzelle einer ersten Kette aufzulegen und mit ihrer anderen Elektrode über ein kurzes Leiterband mit der Rückseite der Solarzelle einer zweiten Kette zu verbinden. Weiterhin kann die Bypassdiode zwischen einer Solarzelle einer ersten Kette und einem zwei Solarzellen einer anderen Kette verbindenden Leiterband geschaltet werden. Zweckmässigerweise wird die Bypassdiode auf einem gleichzeitig zur Kontaktgabe dienenden Kühlblech angeordnet.

Bei der Erfindung sind also die Bypassdioden direkt zusammen mit den einzelnen Solarzellen in den Kunststoffverbund des Solarzellenmoduls eingebaut, was zu einer wesentlich einfacheren Verdrahtung führt und aufwendige Anschlusskästen für die Bypassdioden vermeidet. Die Bypassdioden werden dabei praktisch entweder im Raum zwischen drei Solarzellen oder auf der Rückseite einer Solarzelle untergebracht, die dann gleichzeitig eine gute Kühlfläche bildet.

Nachfolgend wird die Erfindung anhand der Zeichnung näher erläutert. Es zeigen:

Fig. 1 ein Prinzipschaltbild für die Bypassdiode bei einem Solarzellenmodul,

Fig. 2 schematisch ein bisheriges Solarzellenmodul,

Fig. 3a ein Prinzipschaltbild mit mehreren Bypassdioden für ein Ausführungsbeispiel des erfindungsgemässen Solarzellenmoduls,

Fig. 3b eine Draufsicht auf das erfindungsgemässe Solarzellenmodul, dessen Prinzipschaltbild in Fig. 3a dargestellt ist,

Fig. 4a eine erste Möglichkeit zur Unterbringung der Bypassdiode beim erfindungsgemässen Solarzellenmodul,

Fig. 4b eine vergrösserte Einzelheit von Fig. 4a.

Die Fig. 1 und 2 wurden bereits eingangs erläutert.

In den folgenden Figuren sind einander entsprechende Bauteile mit den gleichen Bezugszeichen wie in den Fig. 1 und 2 versehen.

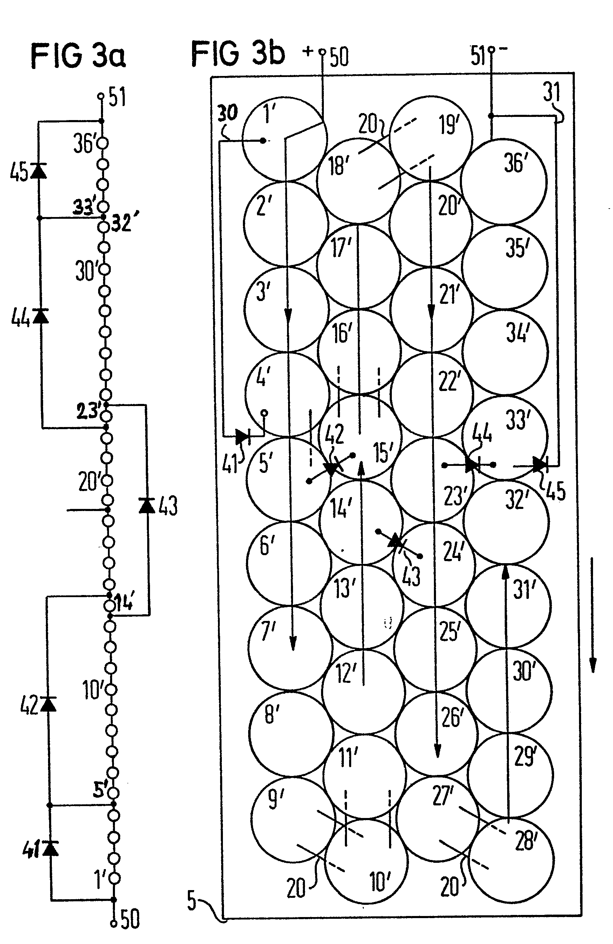

Fig. 3a zeigt das Prinzipschaltbild für das in Fig. 3b dargestellte erfindungsgemässe Solarzellenmodul. In Fig. 3a sind Solarzellen 1' bis 36' in Serie geschaltet. Der Eingang der Solarzelle 1' ist durch eine Bypassdiode 41 an den Ausgang der Solarzelle 4' angeschlossen. Ebenso liegt eine Bypassdiode 42 zwischen dem Eingang der Solarzelle 5' und dem Ausgang der Solarzelle 14'. Eine weitere Bypassdiode 43 ist zwischen dem Eingang der Solarzelle 14' und dem Ausgang der Solarzelle 23' vorgesehen. Ausserdem liegt eine Bypassdiode 44 zwischen dem Eingang der Solarzelle 23' und dem Ausgang der Solarzelle 32'. Schliesslich ist noch eine Bypassdiode 45 zwischen dem Eingang der Solarzelle 33' und dem Ausgang der Solarzelle 36' vorgesehen. Die Bypassdioden 41 und 45 liegen wie die Diode 4 im Beispiel von Fig. 1 parallel zu den ihnen jeweils zugeordneten Ketten aus den Solarzellen 1' bis 4' bzw. 5' bis 14' bzw. 14' bis 23' bzw. 23' bis 32' bzw. 33' bis 36'.

Fig. 3b zeigt, wie die einzelnen Bypassdioden 41 bis 45 in dem Solarzellenmodul 5 angeordnet sind. Die Solarzellen 1' bis 36' sind dabei in Serie geschaltet, wie dies – entsprechend Fig. 2 – durch Pfeile 8 angedeutet ist. In dieser Serie zueinander benachbarte Solarzellen sind dabei über Leitungsbänder 20 miteinander verbunden, von denen schematisch zur Vereinfachung der Darstellung lediglich die die Solarzellen 9' und 10', 18' und 19' sowie 27' und 28' verbindenden Leitungsbänder gezeigt sind. Diese Leitungsbänder 20 führen von der Oberseite einer vorangehenden Solarzelle zur Unterseite der nächst nachfolgenden Solarzelle, damit die gewünschte Serienschaltung entsteht. Auf diese Weise liegen alle Solarzellen 1' bis 36' zwischen einem positiven Anschluss 50 und einem negativen Anschluss 51.

Im Unterschied zum bisherigen Solarzellenmodul, das in Fig. 2 gezeigt ist, wird bei der Erfindung kein aufwendiger Anschlusskasten für die Bypassdioden 41 bis 45 benötigt. Auch kann der Verdrahtungsaufwand wesentlich verringert werden, da lediglich für die Bypassdioden kurze Leiter 30, 31 zwischen den Solarzellen 1' und der Bypassdiode 41 bzw. zwischen der Bypassdiode 45 und dem negativen Anschluss 51 erforderlich sind.

Fig. 4a zeigt, wie beispielsweise die Bypassdiode 43 zwischen der Solarzelle 14' und dem die Solarzellen 23' und 24' verbindenden Leiterband 20 angeordnet werden kann. In Fig. 4b ist eine Einzelheit A von Fig. 4a gezeigt. Dabei ist in der linken Hälfte von Fig. 4b eine Draufsicht und in der rechten Hälfte von Fig. 4b eine Seitensicht dargestellt.

Die eigentliche Bypassdiode 43, d.h. der Diodenchip, liegt einerseits auf einem Kühlblech 53 auf, das mit dem zwischen den Solarzellen 23' und 24' geführten Leiterband 20 verbunden ist, und ist andererseits über ein Anschlussband 52 mit der Unterseite der Solarzelle 14' verbunden. Durch das Kühlblech 53 wird für eine ausreichende Wärmeabfuhr aus der Bypassdiode 43 gesorgt.

## Patentansprüche

1. Solarzellenmodul aus einzelnen, in Reihen angeordneten Solarzellen, die wenigstens teilweise elektrisch in Serie geschaltet sind, mit mindestens einer Bypassdiode, die als normalerweise gesperrte Diode die in Serie geschalteten Solarzellen überbrückt, wobei die Bypassdioden (41–45) direkt in das Solarzellenmodul (5) integriert sind, dadurch gekennzeichnet, dass die Bypassdiode (43) zwischen einer Solarzelle (14') und einem zwei andere Solarzellen (23', 24') verbindenden Leiterband (20) geschaltet ist.

2. Solarzellenmodul nach Anspruch 1, dadurch gekennzeichnet, dass die Bypassdiode (43) auf einem gleichzeitig zur Kontaktgabe dienenden Kühlblech (53) angeordnet ist.

## Claims

1. Solar cells module made of individual solar cells arranged in rows which are at least partially electrically connected in series, having at least one bypass diode which bridges as a normally blocked diode the solar cells connected in series, the bypass diodes (41–45) being integrated directly in the solar cells module (5), characterized in that the bypass diode (43) is connected between a solar cell (14') and a conductor band (20) connecting two other solar cells (23', 24').

2. Solar cells module according to Claim 1, characterized in that the bypass diode (43) is arranged on a cooling plate (53) which serves at the same time for making contact.

## Revendications

1. Module à piles solaires, constitué par des piles solaires individuelles disposées en série, qui sont au moins partiellement branchées électriquement en série, et comportent au moins une diode de dérivation qui, en tant que diode normalement bloquée, shunte les piles solaires branchées en série, les diodes de dérivation (41–45) étant intégrées directement dans le module à piles solaires (5), caractérisé par le fait que la diode de dérivation (43) est branchée entre une pile solaire (14') et une bande conductrice (20) reliant deux autres piles solaires (23', 24').

2. Module à piles solaires suivant la revendication 1, caractérisé par le fait que la diode de dérivation (43) est disposée sur une tôle de refroidissement (53) utilisée simultanément pour l'établissement des contacts.

# FIG 1

# FIG 2

# FIG 4a

# FIG 4b

FIG 3a

FIG 3b